# EUROPEAN PATENT APPLICATION

(11) **EP 2 383 367 A1**
(43) Date of publication of application: **02.11.2011**
(21) Application number: 09838840.8
(22) Date of filing: 15.10.2009
(51) Int. Cl.: C23C 16/458, H01L 21/205, H01L 21/3065, H01L 21/31, H01L 21/683

(54) **SUBSTRATE SUPPORT STAGE OF PLASMA PROCESSING APPARATUS**

(30) Priority: 26.01.2009 JP 2009013808
(71) Applicant: Mitsubishi Heavy Industries, Ltd., Tokyo 108-8215 (JP)
(72) Inventor: MATSUDA, Ryuichi, Takasago-shi Hyogo 676-8686 (JP); MATSUKURA, Akihiko, Kobe-shi Hyogo 652-8585 (JP); UEMITSU, Kenjiro, Kobe-shi Hyogo 652-8585 (JP); YANAGIDA, Hisashi, Kobe-shi Hyogo 652-8585 (JP)
(74) Representative: HOFFMANN EITLE
(86) International application number: PCT/JP2009/067854
(87) International publication number: WO 2010/084650

(57) **Abstract**

An object is to provide a substrate support stage of a plasma processing apparatus, in which electrical discharge from a connection terminal is prevented with a simple structure, In the substrate support stage of a plasma processing apparatus, an electrostatic attraction plate (13) configured to electrostatically attract a substrate (W) and to apply a bias to the substrate (W) is provided on an upper surface of a support stage (10) in a vacuum chamber, a sealing member (12) is provided on the upper surface of the support stage (10), an outer periphery side of the sealing member (12) is hermetically sealed as the vacuum chamber, and a connection terminal (17) commonly used for electrostatic attraction voltage supply and bias power supply is disposed on an atmosphere side which is an inner periphery side of the sealing member (12).

## Description

### TECHNICAL FIELD

The present invention relates to a substrate support stage for supporting a substrate in a plasma processing apparatus.

### BACKGROUND ART

In a plasma processing apparatus, such as a plasma CVD (Chemical Vapor Deposition) apparatus or a plasma etching apparatus, a substrate made of a semiconductor such as Si (silicon) is supported on a substrate support stage. The substrate support stage is provided with an electrostatic chuck which is made of a ceramic (for example, aluminum nitride (A1N) or the like) and which electrostatically attracts and holds the substrate. The electrostatic chuck is provided with a bias electrode for applying a bias to the substrate, a heater for controlling the temperature of the substrate, and the like, in addition to an electrostatic chuck electrode. Thus, the electrostatic chuck has not only a function to attract and hold the substrate, but also functions to apply a bias, and to control temperature.
Patent Document 1: Japanese Patent Application Publication No. 2000-299288
Patent Document 2: Japanese Patent No. 3962661

### DISCLOSURE OF THE INVENTION

### PROBLEMS TO BE SOLVED BY THE INVENTION

As described above, the electrostatic chuck has not only a function to attract and hold a substrate, but also functions to apply a bias and to control temperature. For this reason, the electrostatic chuck needs to be electrically connected to an electrostatic chuck electrode, a bias electrode, a heater, and the like. In general, the electrical connection is established through multiple connection terminals provided on a back surface of the electrostatic chuck.

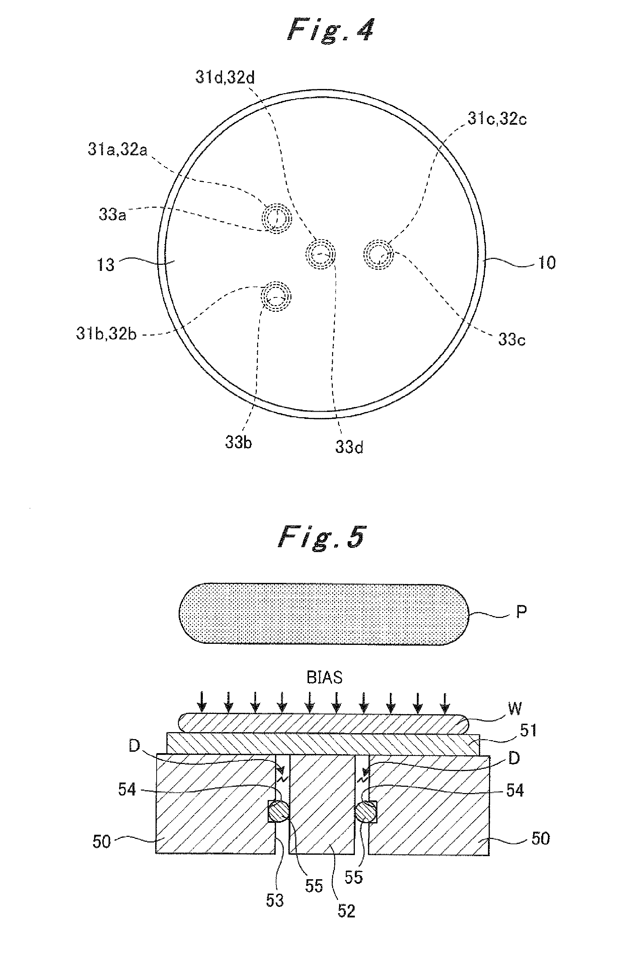

In a plasma processing apparatus, the substrate and the electrostatic chuck are disposed on a vacuum side for the purpose of carrying out plasma processing on the substrate. The connection terminals are led out to an atmosphere side for connection with a control device disposed on the atmosphere side. However, the terminals are partially on the vacuum side. This will be described by use of a longitudinal cross-sectional view of a conventional substrate support stage of a plasma processing apparatus shown in Fig. 5.

The conventional substrate support stage of a plasma processing apparatus includes a support stage 50 disposed inside a vacuum chamber (not illustrated) and an electrostatic chuck 51 disposed on an upper surface of the support stage 50. In the substrate support stage, a connection terminal 52 for connection to a bias/electrostatic chuck common electrode (not illustrated) is led out to the atmosphere side from a back surface of the electrostatic chuck 51 through an opening portion 53 provided in the support stage 50. Here, the connection terminal 52 itself is sealed by use of an O-ring 55 provided in a groove 54 in the middle of the opening portion 53, so that a portion of the connection terminal 52 is on the vacuum side, and the other portion thereof is on the atmosphere side.

In general, electrical discharge is more likely to occur in vacuum than in the atmosphere according to the Paschen's law. Accordingly, in a case of the above-described structure, electrical discharge occurs in a portion of the connection terminal 52 which is disposed on the vacuum side (the portion D in Fig. 5), when a plasma P is generated in the vacuum chamber, the substrate W is electrostatically attracted, and a bias is applied to the substrate W. This may lead to loss in bias power and loss in electrostatic chuck voltage. Particularly, when a high-output electric power is applied to the bias electrode, or when a high voltage is applied to the electrostatic chuck electrode, the electrical discharge is more likely to occur, and the influence exerted by the electrical discharge is increased. Hence, some countermeasures against the electrical discharge have been sought for the connection terminals disposed on the vacuum side. In addition, when the electrical discharge occurs, the maintenance of the portion D is necessary. However, since the portion D has a dead end structure, the ease of maintenance thereof is poor. Moreover, in subsequent evacuation, since the portion D is difficult to evacuate, there is a possibility that the gas may remain therein.

The present invention has been made in view of the above-described problems, and an object of the present invention is to provide a substrate support stage of a plasma processing apparatus, in which electrical discharge from a connection terminal is prevented with a simple structure.

### MEANS FOR SOLVING THE PROBLEMS

A substrate support stage of a plasma processing apparatus according to a first invention which solves the aforementioned problems is a substrate support stage of a plasma processing apparatus, in which an electrostatic attraction plate configured to electrostatically attract a substrate and to apply a bias to the substrate is provided on an upper surface of a support stage in a vacuum chamber, wherein a sealing member is provided on the upper surface of the support stage, an outer periphery side of the sealing member is hermetically sealed as the vacuum chamber, and a connection terminal commonly used for electrostatic attraction voltage supply and bias power supply is disposed on an atmosphere side which is an inner periphery side of the sealing member.

A substrate support stage of a plasma processing apparatus according to a second invention which solves the aforementioned problems is a substrate support stage of a plasma processing apparatus, in which an electrostatic attraction plate configured to electrostatically attract a substrate and to apply a bias to the substrate and incorporating a heater for heating the substrate is provided on an upper surface of a support stage in a vacuum chamber, wherein a sealing member is provided on the upper surface of the support stage in such a manner as to surround along an outer edge of a lower surface of the electrostatic attraction plate, an outer periphery side of the sealing member is hermetically sealed as the vacuum chamber, and a connection terminal commonly used for electrostatic attraction voltage supply and bias power supply, and a connection terminal for supplying electric power to the heater are disposed on an atmosphere side which is an inner periphery side of the sealing member.

A substrate support stage of a plasma processing apparatus according to a third invention which solves the aforementioned problems is a substrate support stage of a plasma processing apparatus, in which an electrostatic attraction plate configured to electrostatically attract a substrate and to apply a bias to the substrate and incorporating a heater for heating the substrate is provided on an upper surface of a support stage in a vacuum chamber, wherein a connection terminal commonly used for electrostatic attraction voltage supply and bias power supply, and a connection terminal for supplying electric power to the heater are disposed close to each other, and a sealing member is provided on the upper surface of the support stage in such a manner as to surround vicinities of the plurality of connection terminals, and an outer periphery side of the sealing member is hermetically sealed as the vacuum chamber, so that the plurality of connection terminals are disposed on an atmosphere side which is an inner periphery side of the sealing member.

A substrate support stage of a plasma processing apparatus according to a fourth invention which solves the aforementioned problems is a substrate support stage of a plasma processing apparatus, in which an electrostatic attraction plate configured to electrostatically attract a substrate and to apply a bias to the substrate and incorporating a heater for heating the substrate is provided on an upper surface of a support stage in a vacuum chamber, wherein a sealing member is provided on the upper surface of the support stage in such a manner as to surround a vicinity of each of a connection terminal commonly used for electrostatic attraction voltage supply and bias power supply and a connection terminal for supplying electric power to the heater, and each of an outer periphery side of the sealing member is hermetically sealed as the vacuum chamber, so that each of the connection terminals is disposed on an atmosphere side which is an inner periphery side of the sealing member.

A substrate support stage of a plasma processing apparatus according to a fifth invention which solves the aforementioned problems is the substrate support stage of a plasma processing apparatus according to any one of the first to fourth inventions, wherein the connection terminal commonly used for electrostatic attraction voltage supply and bias power supply is replaced with connection terminals respectively therefor independent from each other.

### EFFECTS OF THE INVENTION

According to the present invention, the structure is such that the sealing member for the electrostatic attraction plate is provided on the upper surface of the support stage, and the connection terminals are disposed on the atmosphere side, which is the inner periphery side of the sealing member. Hence, electrical discharge by the connection terminals is prevented, and loss in bias power and loss in electrostatic chuck voltage are prevented, so that the bias power and the electrostatic chuck voltage can be supplied efficiently. As a result, it is made possible to apply a high-frequency bias with a large electric power, and also to apply a high electrostatic chuck attraction voltage, so that the performance and the reliability of the plasma processing can be improved. In addition, since the structure is such a simple one that the sealing member for the electrostatic attraction plate is provided on the upper surface of the support stage, the ease of maintenance is also improved. Moreover, when connection terminals to the electrostatic attraction plate are present on the vacuum side, the metal of the connection terminals may degrade upon cleaning using NF₃ gas or the like, and contaminate the inside of the vacuum chamber. In the present invention, however, since the connection terminals to the electrostatic attraction plate are on the atmosphere side, it is advantageous that no contamination occurs in the vacuum chamber due to the degradation of the metal of the connection terminals.

### BRIEF DESCRIPTION OF THE DRAWINGS

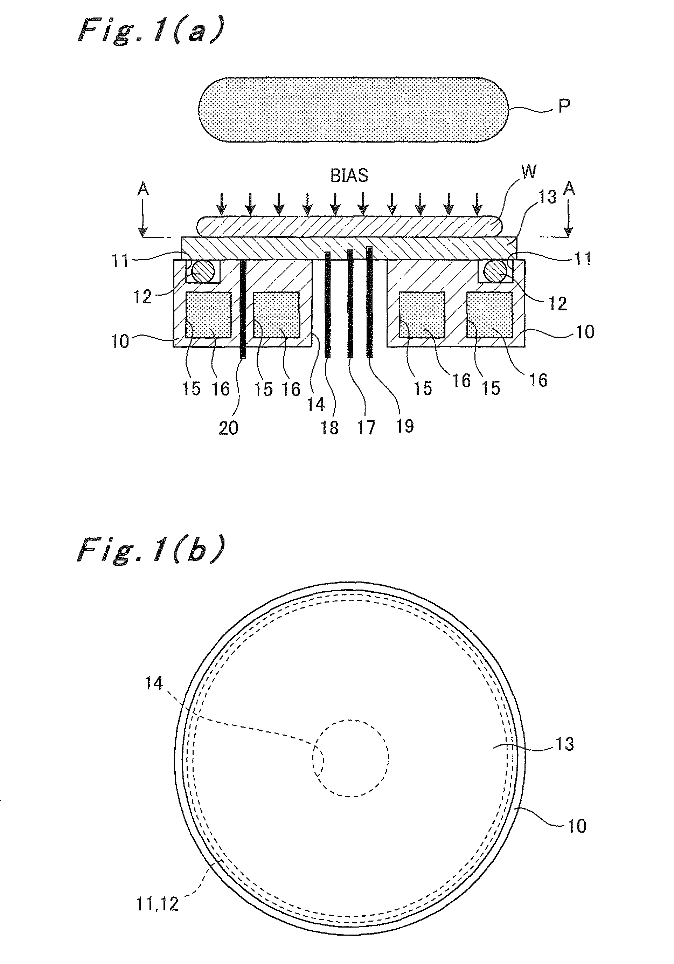

[Fig. 1] Fig. 1 shows views illustrating an example of an embodiment of a substrate support stage of a plasma processing apparatus according to the present invention, where Part (a) is a longitudinal cross-sectional view of the substrate support stage, and Part (b) is a view taken along the line A-A of Part (a) in a direction of the arrows.

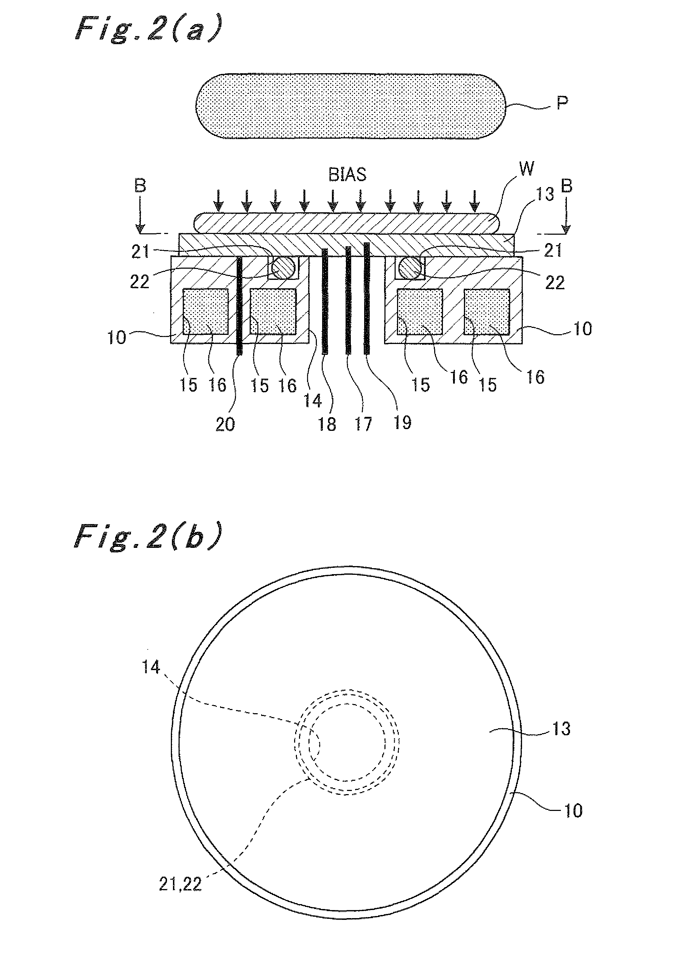

[Fig. 2] Fig. 2 shows views illustrating another example of an embodiment of a substrate support stage of a plasma processing apparatus according to the present invention, where Part (a) is a longitudinal cross-sectional view of the substrate support stage, and Part (b) is a view taken along the line B-B of Part (a) in a direction of the arrows.

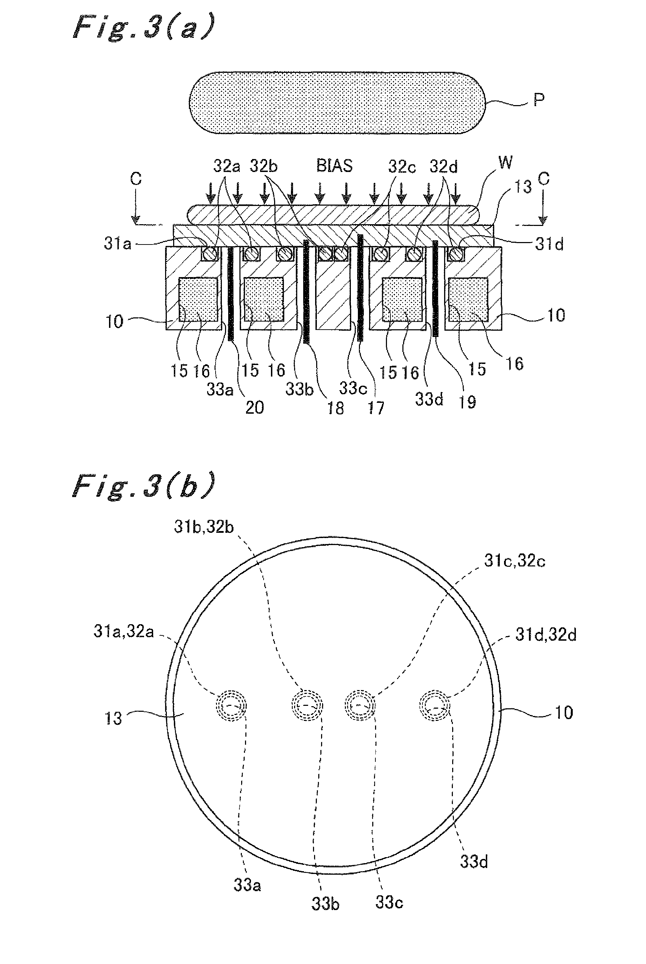

[Fig. 3] Fig. 3 shows views illustrating yet another example of an embodiment of a substrate support stage of a plasma processing apparatus according to the present invention, where Part (a) is a longitudinal cross-sectional view of the substrate support stage, and Part (b) is a view taken along the line C-C of Part (a) in a direction of the arrows.
[Fig. 4] Fig. 4 is a view showing a modification of Part (b) of Fig. 3.
[Fig. 5] Fig. 5 is a longitudinal cross-sectional view of a conventional substrate support stage of a plasma processing apparatus.

### EXPLANATION OF REFERENCE NUMERALS

10 support stage
11, 21, 31 a to 31d O-ring groove
12, 22, 32a to 32d O-ring
13 electrostatic chuck
14, 33a to 33d opening portion
17 common connection terminal
18 heater connection terminal
19 substrate temperature detection sensor terminal
20 chuck temperature detection sensor terminal

### BEST MODES FOR CARRYING OUT THE INVENTION

Description will be given of an embodiment of a substrate support stage of a plasma processing apparatus according to the present invention with reference to Figs. 1 to 4.

### (Embodiment 1)

Fig. 1 shows views illustrating an example of an embodiment of a substrate support stage of a plasma processing apparatus according to the present invention, where Part (a) is a longitudinal cross-sectional view of the substrate support stage, and Part (b) is a view taken along the line A-A of Part (a) in a direction of the arrows. Note that the substrate support stage of this embodiment is to be disposed in a vacuum chamber of a plasma processing apparatus (for example, a plasma CVD apparatus, a plasma etching apparatus, or the like), but herein the structures other than that of the substrate support stage, such as the structures of the vacuum chamber, a plasma generation mechanism, and the like are not shown.

The substrate support stage of this embodiment has a support stage 10 disposed inside a vacuum chamber, and an electrostatic chuck 13 (electrostatic attraction plate) disposed on an upper surface of the support stage 10. The electrostatic chuck 13 is made of a ceramic (for example, aluminum nitride (AIN) or the like) configured to electrostatically attract and hold a substrate W made of a semiconductor such as Si (silicon). The electrostatic chuck 13 incorporates an electrostatic chuck electrode (not illustrated). In addition, the electrostatic chuck 13 incorporates a bias electrode (not illustrated) for applying a bias to a substrate, a heater (not illustrated) for controlling the temperature of a substrate, and the like. In other words, the electrostatic chuck 13 has not only a function to attract and hold a substrate, but also functions to apply a bias and to control the temperature. Note that a single electrode can be commonly used as the electrostatic chuck electrode and the bias electrode, and a single electrode is commonly used in this embodiment.

In addition, an O-ring groove 11 is provided at a position on the upper surface, of the support stage 10, facing the electrostatic chuck 13, in such a manner as to surround along an outer edge on the lower surface of the electrostatic chuck 13. In the O-ring groove 11, an O-ring 12 (sealing member) is disposed. Then, the electrostatic chuck 13 is attached to the support stage 10 by using a clamp (not illustrated), with the O-ring 12 disposed in the O-ring groove 11 being interposed therebetween. In the electrostatic chuck 13, for the purpose of the sealing characteristics with the O-ring 12, the entirety of the back surface or at least a portion to be in contact with the O-ring 12 is made flat, and has a surface roughness of Ra 0.8 or less.

As described above, the seal in the substrate support stage is achieved by the O-ring 12 disposed along the outer edge of the electrostatic chuck 13. An outer periphery side of the O-ring 12 is hermetically sealed as a vacuum chamber side, whereas an inner periphery side of the O-ring 12 is on an atmosphere side. In addition, a common connection terminal 17 for connection to the bias/electrostatic chuck common electrode, and a heater connection terminal 18 for connection to the heater are disposed to be on the atmosphere side, which is the inner periphery side of the O-ring 12, in other words, not to be on the vacuum side.

As for the positions at which the common connection terminal 17 and the heater connection terminal 18 are disposed, the positions may be any within the inner periphery side of the O-ring 12. For example, in this embodiment, an opening portion 14 penetrating the support stage 10 is provided in a center portion of the support stage 10 which is located on the inner periphery side of the 0-ring 12. Through the opening portion 14, the common connection terminal 17 and the heater connection terminal 18 are led out from the back surface of the electrostatic chuck 13 to the lower side. Note that when the electrostatic chuck 13 incorporates no heater, it is only necessary to dispose at least the common connection terminal 17 on the inner periphery side of the O-ring 12. When an electrode is not commonly used for bias and electrostatic chuck, a bias connection terminal and an electrostatic chuck connection terminal may be both disposed on the inner periphery side of the O-ring 12. In addition, when multiple common connection terminals 17 are used for supplying a high electric power, the common connection terminals 17 may be disposed on the inner periphery side of the O-ring 12.

Meanwhile, a substrate temperature sensor terminal 19 which detects the temperature of the substrate W, and a chuck temperature sensor terminal 20 which detects the temperature of the electrostatic chuck 13 may be disposed at any positions as long as the temperature of an object can be detected, and the sealing characteristics can be maintained. In this embodiment, since the O-ring 12 is disposed along the outer edge of the electrostatic chuck 13, the two terminals are disposed at positions on the inner periphery side of the O-ring 12, eliminating the need for separate seals. For example, the substrate temperature sensor terminal 19 is led out from the back surface of the electrostatic chuck 13 thorough the opening portion 14. The chuck temperature sensor terminal 20 is led out from the back surface of the electrostatic chuck 13 by penetrating the support stage 10 itself. Here, a thermocouple, a radiation thermometer, or the like is used as the substrate temperature sensor or the chuck temperature sensor. When a thermocouple is used, the thermocouple itself serves as the connection terminal. When a radiation thermometer is used, an optical fiber which transmits infrared rays emitted from the object serves as the connection terminal.

Accordingly, in this embodiment, when a plasma P is generated in the vacuum chamber, a DC voltage is supplied to the connection terminal 17 to thereby electrostatic attract the substrate W to the electrostatic chuck 13, and a high-frequency power is supplied also to the connection terminal 17 to thereby apply a bias to the substrate W. In this case, since the entirety of the connection terminal 17 is on the atmosphere side (is not on the vacuum side at all), the electrical discharge can be prevented from occurring. Thus, losses in bias power and electrostatic chuck voltage can be prevented. For this reason, for example, even when a high DC voltage close to 1 kV is applied to the connection terminal 17, or even when a high bias power about 1 kW to 4 kW is applied to the connection terminal 17, the electrical discharge can be prevented from occurring. As a result, it is made possible to apply a high-frequency bias with a large electric power, and to apply a high electrostatic chuck attraction voltage, so that the performance and the reliability of the plasma processing can be improved. Moreover, since the structure is such a simple one that the O-ring groove 11 and the O-ring 12 are provided on the upper surface of the support stage 10, the ease of maintenance is also improved, and there is no possibility that gas remains during evacuation.

Moreover, when the connection terminals connected to the electrostatic chuck are present on the vacuum side, the metal of the connection terminals may degrade due to cleaning thereof using a NF₃ gas or the like, and the inside of the vacuum chamber may be contaminated. In this embodiment, however, the connection terminals 17 and 18 and the sensor terminals 19 and 20 connected to the electrostatic chuck 13 are on the atmosphere side. Hence, this embodiment is advantageous in that no contamination occurs in the vacuum chamber by the degradation of the metals of these terminals 17 to 20.

Note that, the electrostatic chuck 13 is desirably cooled because the electrostatic chuck 13 is heated by application of a plasma and a bias. In the case of this embodiment, the air exists in a small gap formed between the support stage 10 and the electrostatic chuck 13 on the inner periphery side of the O-ring 12, and contributes to the heat transfer from the electrostatic chuck 13, so that the cooling efficiency is improved. To improve the cooling efficiency, the heat transfer from the electrostatic chuck 13 to the support stage 10 may be improved as follows. Specifically, a carbon sheet, a thermal grease, or the like which brings the support stage 10 and the electrostatic chuck 13 into close contact with each other is interposed between the support stage 10 and the electrostatic chuck 13 on the inner periphery side (the atmosphere side) of the O-ring 12. To further improve the cooling efficiency, the support stage 10 itself may be cooled by forming, in the support stage 10, a flow path 15 for allowing a coolant 16 for cooling to flow therethrough. Note that, since a portion, which faces the opening portion 14, of the back surface of the electrostatic chuck 13 is exposed to the atmosphere, an effect of natural cooling can also be expected.

Accordingly, in a case of such a structure, a voltage applied to the heater connection terminal 18 of the heater contained in the electrostatic chuck 13 may be controlled, and simultaneously the temperature and the flow rate of the coolant 16 flowing through the flow path 15 of the support stage 10 may be controlled so that the temperature of the substrate W detected by the substrate temperature sensor 17 can be constant during processing.

### (Embodiment 2)

Fig. 2 shows views illustrating another example of an embodiment of a substrate support stage of a plasma processing apparatus according to the present invention, where Part (a) is a longitudinal cross-sectional view of the substrate support stage, and Part (b) is a view taken along the line B-B of Part (a) in a direction of the arrows. Note that the substrate support stage of this embodiment is also to be disposed in a vacuum chamber of a plasma processing apparatus, but herein the structures other than that of the substrate support stage, such as the structures of the vacuum chamber, a plasma generation mechanism, and the like are also not shown. In addition, components equivalent to those in the structure of the substrate support stage shown in Embodiment 1 are denoted by the same reference numerals, and overlapping description thereof is omitted.

As shown in Fig. 2, a substrate support stage of this embodiment has the same structure as the substrate support stage shown in Embodiment 1, except that the O-ring is disposed at a different position. Specifically, in this embodiment, the common connection terminal 17 and the heater connection terminal 18 are disposed close to each other, and simultaneously an O-ring groove 21 is provided on the upper surface of the support stage 10 around the opening portion 14 which surrounds the vicinity of the common connection terminal 17 and the heater connection terminal 18. In the O-ring groove 21, an O-ring 22 (sealing member) is disposed. Then, the electrostatic chuck 13 is attached to the support stage 10 by using a clamp (not illustrated), with the O-ring 22 disposed in the O-ring groove 21 being interposed therebetween. In the electrostatic chuck 13, for the purpose of the sealing characteristics with the O-ring 22, the entirety of the back surface or at least a portion to be in contact with the O-ring 22 is made flat, and has a surface roughness of Ra 0.8 or less.

As described above, the seal in the substrate support stage is achieved by the O-ring 22. By hermetically sealing an outer periphery side of the O-ring 22 as the vacuum chamber side, the common connection terminal 17 and the heater connection terminal 18 are disposed to be on the atmosphere side, which is the inner periphery side of the O-ring 22, in other words, not to be on the vacuum side.

In addition, the O-ring groove 21 and the O-ring 22 are disposed, at a position more inside in the radial direction, i.e., at such a position as to have a smaller diameter, than the O-ring groove 11 and the O-ring 12 in Embodiment 1 (see Fig. 1). When the inside of the vacuum chamber is evacuated, a force originated from the atmospheric pressure acts on a portion over which the electrostatic chuck 13 is exposed to the atmospheric pressure. By making the diameter of the O-ring 22 smaller as in this embodiment, the area of the portion over which the electrostatic chuck 13 is exposed to the atmospheric pressure is reduced, so that the force of the atmospheric pressure pushing the electrostatic chuck 13 upward is reduced. Hence, the O-ring 22 preferably has a diameter as small as possible.

For example, in this embodiment, the opening portion 14 penetrating the support stage 10 is provided in a center portion of the support stage 10; the O-ring groove 21 and the O-ring 22 are disposed on the upper surface of the support stage 10 around the opening portion 14; and the common connection terminal 17, the heater connection terminal 18, and the substrate temperature sensor terminal 19 are led out to the lower side, from the back surface of the electrostatic chuck 13, through the opening portion 14 on the inner periphery side of the O-ring 22. Note that when the electrostatic chuck 13 incorporates no heater, it is only necessary to dispose at least the common connection terminal 17 on the inner periphery side of the O-ring 22. When an electrode is not commonly used for bias and electrostatic chuck, a bias connection terminal and an electrostatic chuck connection terminal may be both disposed on the inner periphery side of the O-ring 22. In addition, when multiple common connection terminals 17 are used for supplying a high electric power, the common connection terminals 17 may be disposed on the inner periphery side of the O-ring 22.

Meanwhile, the substrate temperature sensor terminal 19 and the chuck temperature sensor terminal 20 may be disposed at any positions, as long as the temperature of an object can be detected, and the sealing characteristics can be maintained. In this embodiment, for example, the substrate temperature sensor terminal 19 is led out from the back surface of the electrostatic chuck 13, through the opening portion 14, whereas the chuck temperature sensor terminal 20 is led out from the back surface of the electrostatic chuck 13 by penetrating the support stage 10 itself.

In other words, when the number of the connection terminals passing through the opening portion 14 on the inner periphery side of the O-ring 22 is reduced as much as possible, the diameter of the O-ring 22 can be reduced as much as possible. As a result, the force of the atmospheric pressure pushing the electrostatic chuck 13 upward can be reduced as much as possible. Meanwhile, when all the connection terminals and the sensor terminals to the electrostatic chuck 13 are collectively disposed at a single position in the opening portion 14 on the inner periphery side of the O-ring 22, the structure of the support stage 10 can be simplified, so that the production costs can be reduced, and the ease of maintenance can be improved.

Note that, when the common connection terminal 17 and the heater connection terminal 18 are disposed close to each other, the common connection terminal 17 and the heater connection terminal 18 8 are disposed so distant from each other that no electrical discharge occurs at least at atmospheric pressure. In addition, the position of the inner diameter of the opening portion 14 through which the common connection terminal 17 and the heater connection terminal 18 pass is disposed so distant from each both terminals 17,18 that no electrical discharge occurs at atmospheric pressure.

Accordingly, with the above-described structure, the electrical discharge can be prevented from occurring also in this embodiment as in the case with Embodiment 1, so that losses in bias power and electrostatic chuck voltage can be prevented. As a result, it is made possible to apply a high-frequency bias with a large electric power, and to apply a high electrostatic chuck attraction voltage, so that the performance and the reliability of the plasma processing can be improved. In addition, since the structure is such a simple one that the O-ring groove 21 and the O-ring 22 are provided on the upper surface of the support stage 10, the ease of maintenance is also improved, and there is no possibility that gas remains during evacuation.

In this embodiment, only the chuck temperature sensor terminal 20 is present on the vacuum side, but the connection terminals 17 and 18, and the substrate temperature sensor tenninal 19 which are connected to the electrostatic chuck 13 are on the atmosphere side. Hence, the metal of these terminals 17 to 19 does not degrade, and the contamination in the vacuum chamber due to the degrading of the metal can be reduced.

Note that, to improve the cooling efficiency, the following structure may be employed because a carbon sheet exerts no influence on the vacuum. Specifically, a carbon sheet which brings the support stage 10 and the electrostatic chuck 13 into close contact with each other is interposed between the support stage 10 and the electrostatic chuck 13 on the outer periphery side (on the vacuum side) of the O-ring 22, to thereby improve the heat transfer from the electrostatic chuck 13 to the support stage 10. To further improve the cooling efficiency, the flow path 15 for allowing the coolant 16 for cooling to flow therethrough is formed in the support stage 10 so that the support stage 10 itself can be cooled as in the case with Embodiment 1. Note that, since the portion, which faces the opening portion 14, of the back surface of the electrostatic chuck 13 is exposed to the atmosphere, an effect of natural cooling can also be expected.

### (Embodiment 3)

Fig. 3 shows views illustrating yet another example of an embodiment of a substrate support stage of a plasma processing apparatus according to the present invention, where Part (a) is a longitudinal cross-sectional view of the substrate support stage, and Part (b) is a view taken along the line C-C of Part (a) in a direction of the arrows. Note that the substrate support stage of this embodiment is also to be disposed in a vacuum chamber of a plasma processing apparatus, but herein the structures other than that of the substrate support stage, such as the structures of the vacuum chamber, a plasma generation mechanism, and the like are also not shown. In addition, components equivalent to those in the structure of the substrate support stage shown in Embodiments 1 and 2 are denoted by the same reference numerals, and overlapping description thereof is omitted.

As shown in Fig. 3, the substrate support stage of this embodiment has substantially the same structure as the substrate support stages shown in Embodiments 1 and 2. However, the terminals, the opening portion, the O-ring groove and the O-ring are disposed at different positions. Specifically, in this embodiment, the terminals 17 to 20 connected to the electrostatic chuck 13 are not disposed close to each other, but disposed in a dispersed manner. Opening portions 33a to 33d are provided for the terminals 17 to 20, respectively. O-ring grooves 31a to 31d and the O-rings 32a to 32d (sealing members) are disposed on the upper surface of the support stage 10 around the opening portions 33a to 33d, respectively. Then, the electrostatic chuck 13 is attached to the support stage 10 by using a clamp (not illustrated), with the O-rings 32a to 32d respectively disposed in the O-ring grooves 31a to 31d being interposed therebetween. In the electrostatic chuck 13, for the purpose of the sealing characteristics with the O-rings 32a to 32d, the entirety of the back surfaces or at least portions to be in contact with the O-ring 32a to 32d are made flat, and have a surface roughness of Ra 0.8 or less.

As described above, the seal in the substrate support stage is achieved by the O-rings 32a to 32d having smaller diameters. By hermetically sealing the outer periphery side of the O-rings 32a to 32d as the vacuum chamber side, the terminals 17 to 20 are disposed to be on the atmosphere side, which is the inner periphery side of the O-rings 32a to 32d, in other words, not to be on the vacuum side.

In addition, the O-ring grooves 31a to 31d and the O-rings 32a to 32d are provided for the terminals, respectively. Hence, the diameter of each of the O-rings 32a to 32 can be made smaller than those of the O-ring groove 21 and the O-ring 22 in Embodiment 2 (see Fig. 2). By providing the O-rings 32a to 32d for the terminals, respectively, and reducing the diameter of each of the O-rings 32a to 32d as much as possible as described above, the portions over which the electrostatic chuck 13 exposed to the atmospheric pressure are dispersed, and the areas thereof are reduced, so that the force of the atmospheric pressure pushing the electrostatic chuck 13 upward is further reduced.

For example, in this embodiment, the opening portion 33a penetrating the support stage 10 is provided for the chuck temperature sensor terminal 20, and the chuck temperature sensor terminal 20 is led out from the back surface of the electrostatic chuck 13 through the opening portion 33a. Then, the O-ring groove 3 1a is provided on the upper surface of the support stage 10 around the opening portion 33a which surrounds the vicinity of the chuck temperature sensor terminal 20, and the O-ring 32a is disposed in the O-ring groove 31a. Note that, as long as the temperature of the chuck can be detected, and the sealing characteristics can be maintained, it is not necessary to provide the O-ring groove 31a, the O-ring 32a, and the opening portion 33a for the chuck temperature sensor terminal 20.

In addition, the opening portion 33b penetrating the support stage 10 is provided for the heater connection terminal 18. The heater connection terminal 18 is led out from the back surface of the electrostatic chuck 13 through the opening portion 33b. Then, the O-ring groove 31b is provided on the upper surface of the support stage 10 around the opening portion 33b which surrounds the vicinity of the heater connection terminal 18, and the O-ring 32b is disposed in the O-ring groove 31b, Note that when the electrostatic chuck 13 incorporates no heater, the heater connection terminal 18, the O-ring groove 31b, the O-ring 32b, and the opening portion 33b are not necessary.

In addition, the opening portion 33c penetrating the support stage 10 is provided for the common connection terminal 17. The common connection terminal 17 is led out from the back surface of the electrostatic chuck 13 trough the opening portion 33c. Then, the O-ring groove 31c is provided on the upper surface of the support stage 10 around the opening portion 33c which surrounds the vicinity of the common connection terminal 17, and the O-ring 32c is disposed in the O-ring groove 31c. Note that when an electrode is not commonly used for bias and electrostatic chuck, opening portions penetrating the support stage 10 may be provided for a bias connection terminal and an electrostatic chuck connection terminal, respectively, and an O-ring groove and an O-ring may be provided on the upper surface of the support stage 10 around each of the opening portions. Similarly, also when multiple common connection terminals 17 are used for supplying a high electric power, opening portions penetrating the support stage 10 may be provided for the common connection terminals 17, respectively, and an O-ring groove and an O-ring may be provided on the upper surface of the support stage 10 around each of the opening portions.

In addition, the opening portion 33d penetrating the support stage 10 is provided for the substrate temperature sensor terminal 19. The substrate temperature sensor terminal 19 is led out from the back surface of the electrostatic chuck 13 through the opening portion 33d. Then, the O-ring groove 31d is provided on the upper surface of the support stage 10 around the opening portion 33d which surrounds the vicinity of the substrate temperature sensor terminal 19, and the O-ring 32d is disposed in the O-ring groove 31d. Note that, as long as the temperature of the substrate W can be detected, and the sealing characteristics can be maintained, it is not necessary to provide the O-ring groove 31d, the O-ring 32d, and the opening portion 33d for the substrate temperature sensor terminal 19.

Note that the position of the inner diameter of the opening portion 33c through which the common connection terminal 17 passes, and the position of the inner diameter of the opening portion 33b through which the heater connection terminal 18 passes are disposed so distant from each terminals 17, 18 8 that no electrical discharge occurs at atmospheric pressure.

In addition, in this embodiment, as shown in Part (b) of Fig. 3, the sets of the O-ring grooves, the O-rings, and the opening portions (the O-ring grooves 31a to 31d, the O-rings 32a to 32d, and the opening portions 33a to 33d) are arranged side by side in a row. However, the O-ring grooves, the O-rings, and the opening portions may be disposed depending on the purposes of the terminals. Hence, the degrees of freedom of positions where they are to be disposed are high. For example, to detect the temperature at the center of the substrate W, the substrate temperature sensor terminal 19 and the corresponding O-ring groove 31d, O-ring 32d, and opening portion 33d may be disposed at a position corresponding to the center of the substrate W as shown in Fig. 4. Meanwhile, when the positions of the connection with the terminals are limited to a center portion or an edge portion, the terminals and the corresponding O-ring groove, O-ring, and opening portion may be disposed at a position corresponding to the position.

In addition, although not shown in Fig. 3, in fact, multiple lift pins for lifting the substrate W during transfer are present in the support stage 10 and the electrostatic chuck 13. In this respect, by disposing the terminals and the corresponding O-ring grooves, O-rings, and opening portions to avoid interference with the positions of the lift pins, the terminals can be disposed on the atmosphere side, and the lift pins can be disposed on the vacuum side.

Accordingly, with the above-described structure, the electrical discharge can be prevented from occurring, and loss in bias power and loss in electrostatic chuck voltage can be prevented also in this embodiment as in the cases with Embodiments 1 and 2. As a result, it is made possible to apply a high-frequency bias with a large electric power, and also to apply a high electrostatic chuck attraction voltage, so that the performance and the reliability of the plasma processing can be improved. In addition, the structure is such a simple one that the O-ring grooves 31a to 31d and the O-rings 32a to 32d are provided on the upper surface of the support stage 10, the ease of maintenance is also improved, and there is no possibility that gas remains during evacuation.

Moreover, also in this embodiment, since the connection terminals 17 and 18 and the sensor terminals 19 and 20 connected to the electrostatic chuck 13 are on the atmosphere side, it is advantageous that no contamination occurs in the vacuum chamber due to the degradation of the mental of the terminals 17 to 20.

Note that, to improve the cooling efficiency, the following structure may be employed because a carbon sheet exerts no influence on the vacuum. Specifically, a carbon sheet which brings the support stage 10 and the electrostatic chuck 13 into close contact with each other is interposed between the support stage 10 and the electrostatic chuck 13 on the outer periphery side of the O-rings 32a to 32d (on the vacuum side), so that the heat transfer from the electrostatic chuck 13 to the support stage 10 can be improved. To further improve the cooling efficiency, as in the case with Embodiment 1, a flow path 15 for allowing a coolant 15 for cooling to flow therethrough may be formed in the support stage 10, so that the support stage 10 itself can be cooled. Note that since the portions, which face the opening portions 33a to 33d, of the back surface of the electrostatic chuck 13 are exposed to the atmosphere, an effect of natural cooling can also be expected.

### INDUSTRIAL APPLICABILITY

The present invention is suitable for a plasma processing apparatus which applies a bias to a substrate, especially a plasma processing apparatus which is required to use a high-frequency bias with a high electric power.

## Claims

1. A substrate support stage of a plasma processing apparatus, in which an electrostatic attraction plate configured to electrostatically attract a substrate and to apply a bias to the substrate is provided on an upper surface of a support stage in a vacuum chamber, wherein
a sealing member is provided on the upper surface of the support stage,
an outer periphery side of the sealing member is hermetically sealed as the vacuum chamber, and
a connection terminal commonly used for electrostatic attraction voltage supply and bias power supply is disposed on an atmosphere side which is an inner periphery side of the sealing member.

2. A substrate support stage of a plasma processing apparatus, in which an electrostatic attraction plate configured to electrostatically attract a substrate and to apply a bias to the substrate and incorporating a heater for heating the substrate is provided on an upper surface of a support stage in a vacuum chamber, wherein
a sealing member is provided on the upper surface of the support stage in such a manner as to surround along an outer edge of a lower surface of the electrostatic attraction plate,
an outer periphery side of the sealing member is hermetically sealed as the vacuum chamber, and
a connection terminal commonly used for electrostatic attraction voltage supply and bias power supply, and a connection terminal for supplying electric power to the heater are disposed on an atmosphere side which is an inner periphery side of the sealing member.

3. A substrate support stage of a plasma processing apparatus, in which an electrostatic attraction plate configured to electrostatically attract a substrate and to apply a bias to the substrate and incorporating a heater for heating the substrate is provided on an upper surface of a support stage in a vacuum chamber, wherein
a connection terminal commonly used for electrostatic attraction voltage supply and bias power supply, and a connection terminal for supplying electric power to the heater are disposed close to each other, and
a sealing member is provided on the upper surface of the support stage in such a manner as to surround vicinities of the plurality of connection terminals, and
an outer periphery side of the sealing member is hermetically sealed as the vacuum chamber, so that the plurality of connection terminals are disposed on an atmosphere side which is an inner periphery side of the sealing member.

4. A substrate support stage of a plasma processing apparatus, in which an electrostatic attraction plate configured to electrostatically attract a substrate and to apply a bias to the substrate and incorporating a heater for heating the substrate is provided on an upper surface of a support stage in a vacuum chamber, wherein
a sealing member is provided on the upper surface of the support stage in such a manner as to surround a vicinity of each of a connection terminal commonly used for electrostatic attraction voltage supply and bias power supply and a connection terminal for supplying electric power to the heater, and
each of an outer periphery side of the sealing member is hermetically sealed as the vacuum chamber, so that each of the connection terminals is disposed on an atmosphere side which is an inner periphery side of the sealing member.

5. The substrate support stage of a plasma processing apparatus according to any one of claims 1 to 4, wherein
the connection terminal commonly used for electrostatic attraction voltage supply and bias power supply is replaced with connection terminals respectively therefor independent from each other.
